(19) Europäisches Patentamt
European Patent Office
Office européen des brevets

(11) **EP 3 086 322 B1**

(12) **FASCICULE DE BREVET EUROPEEN**

(45) Date de publication et mention
de la délivrance du brevet:
**11.09.2019 Bulletin 2019/37**

(21) Numéro de dépôt: **16165667.3**

(22) Date de dépôt: **15.04.2016**

(51) Int Cl.:
*G11C 16/10* *(2006.01)*   *G11C 16/12* *(2006.01)*
*G11C 29/24* *(2006.01)*   *G11C 29/50* *(2006.01)*
*H01L 27/115* *(2017.01)*   *G11C 29/02* *(2006.01)*
*G11C 16/04* *(2006.01)*   *G11C 29/04* *(2006.01)*

(54) **PROCÉDÉ DE DÉTERMINATION D'UNE IMPULSION DE TENSION OPTIMALE POUR PROGRAMMER UNE CELLULE MÉMOIRE FLASH**

VERFAHREN ZUR BESTIMMUNG EINES OPTIMALEN SPANNUNGSIMPULSES ZUM PROGRAMMIEREN EINER FLASH-SPEICHERZELLE

METHOD FOR DETERMINING AN OPTIMAL VOLTAGE PULSE FOR PROGRAMMING A FLASH MEMORY CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.04.2015 FR 1553558**

(43) Date de publication de la demande:
**26.10.2016 Bulletin 2016/43**

(73) Titulaire: **COMMISSARIAT À L'ÉNERGIE ATOMIQUE ET AUX ÉNERGIES ALTERNATIVES
75015 Paris (FR)**

(72) Inventeur: **COIGNUS, Jean
38000 Grenoble (FR)**

(74) Mandataire: **Cabinet Camus Lebkiri
25 rue de Maubeuge
75009 Paris (FR)**

(56) Documents cités:
**US-A- 5 856 946       US-A- 6 040 996
US-A1- 2006 164 898    US-B1- 8 902 627**

• **V. DELLA MARCA ET AL: "Push the flash floating gate memories toward the future low energy application", SOLID STATE ELECTRONICS., vol. 79, 1 janvier 2013 (2013-01-01), pages 210-217, XP055255268, GB ISSN: 0038-1101, DOI: 10.1016/j.sse.2012.09.001**

**Description**

**DOMAINE TECHNIQUE**

La présente invention s'inscrit dans le domaine des mémoires non volatiles à grille flottante et s'intéresse plus particulièrement aux conditions de programmation électrique d'une cellule de mémoire flash.

**ÉTAT DE LA TECHNIQUE**

Une mémoire « EEPROM-Flash » (communément appelée mémoire flash) est classiquement formée d'une pluralité de cellules mémoire identiques pouvant être programmées électriquement de manière individuelle, un grand nombre de cellules, appelé bloc, secteur ou page, pouvant être effacées simultanément et électriquement.

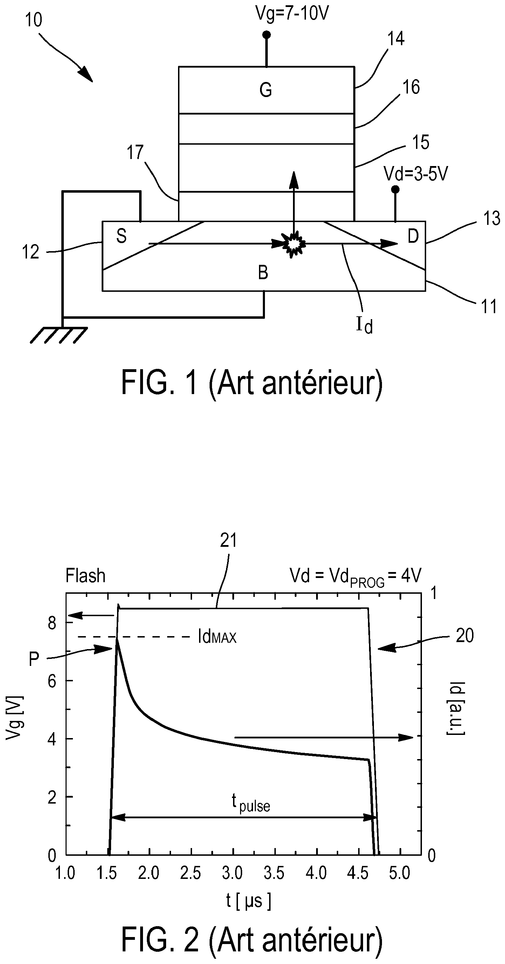

La figure 1 représente schématiquement une cellule de mémoire flash 10 de type 1T-NOR, ainsi que le mécanisme de programmation de cette cellule.

La cellule mémoire flash 10 est constituée d'un transistor NMOS comprenant un substrat 11 en matériau semi-conducteur, une région de source 12 et une région de drain 13 formées dans le substrat 11, et une grille de contrôle 14. Ce transistor comprend en outre un site de stockage de charges électriques 15, appelé grille flottante, formé par exemple d'une couche de polysilicium disposée entre deux couches d'oxyde 16 et 17. La grille flottante 15 est située entre la grille de contrôle 14 et le substrat 11. Le substrat 11, la source 12, le drain 13 et la grille de contrôle 14 constituent des électrodes de commande de la cellule mémoire 10, notées respectivement B (pour « bulk » en anglais), S, D et G sur la figure 1.

La programmation d'une cellule mémoire flash, appelé également écriture, s'effectue en appliquant simultanément une tension Vg élevée sur la grille de contrôle 14, par exemple entre 7 V et 10 V, et une tension Vd plus modérée sur le drain 13 du transistor à grille flottante, par exemple entre 3 V et 5 V (le substrat 11 et la source 12 sont reliés à la masse). Comme cela est schématisé sur la figure 1, ces tensions provoquent l'apparition d'un canal de conduction dans le substrat 11, entre la source 12 et le drain 13, et d'un courant source-drain, porté par des électrons de forte énergie (dits électrons « chauds »). Ces électrons parcourent le canal depuis la source 12 en direction du drain 13. Certains électrons entrent en collision avec les atomes du substrat 11 situés à proximité du drain 13, ce qui conduit à un phénomène d'ionisation par impact de ces atomes et à l'injection d'électrons dans la grille flottante 15, par effet tunnel à travers la couche d'oxyde 17 (dit « oxyde tunnel »).

L'état écrit ou effacé de la cellule mémoire 10 dépend de la concentration d'électrons piégés dans la grille flottante 15. Dans l'état écrit (niveau logique '1'), la grille flottante 15 est remplie d'électrons. La tension de seuil du transistor à grille flottante est élevée (typiquement, entre 6 V et 9 V). A l'inverse, dans l'état effacé (niveau logique '0'), la grille flottante 15 est vide d'électrons. La tension de seuil du transistor est faible (typiquement, entre 2 V et 4 V).

Pendant la programmation de la cellule mémoire 10, une infime partie des électrons issus de la source 12 est piégée dans la grille flottante 15 (environ 1 électron piégé pour $10^6$ électrons injectés dans le canal). L'autre partie des électrons, collectée par le drain 13, constitue le courant de drain Id à l'origine de la consommation électrique de la cellule mémoire 10. L'énergie Ec consommée par la cellule mémoire 10 pendant sa programmation s'écrit :

$$Ec = \int_{t_{pulse}} Vd(t).Id(t).dt = Vd_{PROG}. \int_{t_{pulse}} Id(t).dt$$

où Vd(t) est la tension appliquée sur le drain au cours du temps, Id(t) est le courant de drain au cours du temps et $t_{pulse}$ est la durée de l'opération de programmation. La durée $t_{pulse}$ est généralement comprise entre 1 $\mu$s et 10 $\mu$s. Pendant toute la durée de programmation, la tension Vd(t) est une constante, notée ci-dessus $Vd_{PROG}$ (ici $Vd_{PROG}$ = 3-5 V).

Outre l'énergie consommée Ec, il est d'usage de définir deux autres paramètres pour caractériser la programmation d'une cellule mémoire flash :

- la valeur maximale $Id_{MAX}$ du courant de drain de la cellule mémoire pendant la programmation ; et
- la fenêtre de programmation PW (« Programming Window » en anglais), qui correspond à la différence des tensions de seuil entre l'état écrit (ou « programmé ») et l'état effacé de la cellule mémoire.

Une mesure dynamique du courant de drain Id pendant la programmation de la cellule mémoire flash permet d'obtenir deux de ces paramètres : l'énergie consommée Ec et la valeur maximale $Id_{MAX}$ du courant de drain. Pour réaliser cette mesure, on utilise généralement un appareil appelé PIV (« Pulsed I-V system » en anglais) ou FMU (« Fast Measurement Unit ») permettant de générer des impulsions de tension sur le drain 13 et sur la grille de contrôle 14, tout en mesurant dynamiquement des courants entre 1 μA et 10 mA (typiquement avec une durée d'échantillonnage de l'ordre de 10 ns).

La figure 2 est un exemple de mesure dynamique du courant de drain en fonction du temps, Id(t), lors d'une programmation de la cellule mémoire 10. Au relevé du courant Id(t), on a superposé l'impulsion de tension 20 appliquée sur la grille de contrôle 14 de la cellule mémoire 10, autrement dit le potentiel Vg(t). L'impulsion de tension 20 a une forme classique, globalement rectangulaire. Elle comprend un plateau 21 à environ 8,5 V (Vg(t) = 8,5 V). La durée de programmation $t_{pulse}$, égale à la durée de l'impulsion 20, vaut approximativement 3 μs. Le drain est polarisé à un potentiel Vd égale à 4 V (Vd = $Vd_{PROG}$ = 4 V) pendant toute la durée de programmation.

On constate sur la figure 2 que le courant de drain Id décroit au cours de la programmation, après avoir atteint la valeur maximale $Id_{MAX}$ au début de l'impulsion 20. Cela est dû au fait que la charge électrique de la grille flottante 15 diminue progressivement en se remplissant d'électrons, ce qui entraine une augmentation de la tension de seuil du transistor à grille flottante.

Comme cela est visible sur la figure 2, la décroissance du courant de drain Id est beaucoup plus rapide en début de programmation qu'en fin de programmation. Autrement dit, la vitesse de programmation est beaucoup plus importante au début qu'à la fin de l'impulsion de tension 20. Or la vitesse de programmation influe directement sur la durée de programmation nécessaire pour atteindre une valeur seuil de fenêtre de programmation. En effet, plus la vitesse de programmation est élevée, plus le courant d'électrons vers la grille flottante (i.e. à travers l'oxyde tunnel) est élevé et plus la grille flottante se remplie d'électrons rapidement.

Cette variation de la vitesse de programmation est due au fait qu'une impulsion de tension rectangulaire est utilisée pour polariser la grille de contrôle de la cellule mémoire. Un autre inconvénient d'utiliser une impulsion de forme rectangulaire est le pic de courant P se produisant au début de l'impulsion 20 (Fig.2). Ce pic de courant est préjudiciable pour la cellule mémoire, car il détermine dans quelle mesure doivent être dimensionnés le transistor à grille flottante et les pompes de charge qui alimentent la cellule en courant. Plus le courant $Id_{MAX}$ atteint par ce pic est important, plus le transistor à grille flottante et les pompes de charge de la mémoire occupent une surface de circuit importante. Avec une impulsion de tension rectangulaire, les pompes de charge fournissent le courant $Id_{MAX}$ durant quelques nanosecondes seulement. Le reste du temps, elles sont sous-utilisées (et donc surdimensionnées).

L'optimisation de la programmation d'une cellule mémoire dépend de l'application qui est visée et résulte généralement d'un compromis entre les trois paramètres de programmation : l'énergie consommée Ec, la valeur maximale $Id_{MAX}$ du courant de drain et la fenêtre de programmation PW. Par exemple, pour une mémoire économe en énergie, on cherchera à diminuer autant que possible l'énergie consommée Ec, au détriment de la valeur maximale $Id_{MAX}$ du courant de drain et/ou de la fenêtre de programmation PW. Au contraire, pour une mémoire de forte densité d'intégration, le transistor à grille flottante de la cellule mémoire doit être le plus petit possible. On cherchera donc à réduire le courant maximal de drain $Id_{MAX}$ dont dépendent les dimensions du transistor. En contrepartie, l'énergie Ec consommée par la cellule sera plus élevée.

Pour optimiser la programmation de la cellule mémoire compte tenu de l'application visée, on peut adapter son procédé de fabrication et/ou jouer sur la forme de l'impulsion de tension appliquée sur la grille de contrôle.

Dans le document ["Push the flash floating gate memories toward the future low energy application", V. Della Marca et al., Solid-State Electronics 79, pp.210-217, 2013], différentes formes d'impulsion de tension sont étudiées. Les impulsions sont de type rectangulaire (« box pulse »), c'est-à-dire formées d'un plateau, de type rampe ou constituée de la combinaison d'une rampe et d'un plateau. Pour chaque forme d'impulsion, son impact sur la consommation énergétique Ec, la fenêtre de programmation PW et le courant maximal de drain $Id_{MAX}$ est déterminé expérimentalement.

Les résultats de cette étude permettent de choisir la forme d'impulsion de tension donnant le meilleur compromis entre les trois paramètres de programmation (dans les limites du cahier des charges fixé par le fabricant selon l'application visée), et donc de déterminer les conditions optimales de programmation. Il s'agit cependant que d'une approche a posteriori pour déterminer les conditions de programmation. Cette approche requiert de tester de nombreuses impulsions de tension pour en obtenir une qui satisfasse les trois paramètres de programmation.

Par ailleurs, le document US6040996 divulgue un procédé de programmation d'une cellule mémoire Flash au moyen d'une impulsion de grille trapézoïdale, c'est-à-dire une rampe de tension depuis un niveau initial non-nul. Cette forme d'impulsion implique un courant tunnel (ou courant de grille) constant et donc une vitesse de programmation constante. L'impulsion trapézoïdale permet ainsi, par rapport à une impulsion de grille classique rectangulaire, de réduire le pic de courant au début de la programmation et la durée de programmation.

Le document US5856946 divulgue également un procédé de programmation d'une cellule mémoire Flash ayant pour but de réduire la durée de programmation. Ce but est atteint au moyen d'une impulsion de grille trapézoïdale, i.e. en forme de rampe linéaire ou discontinue, agencée de sorte que le courant de grille (flux d'électrons du canal vers la grille flottante) soit constant.

Aucun de ces documents n'indique toutefois comment est choisie l'impulsion de grille trapézoïdale.

**EP 3 086 322 B1**

**RÉSUMÉ DE L'INVENTION**

Il existe donc un besoin de prévoir un procédé simple et rapide pour déterminer l'impulsion de tension à appliquer sur la grille de contrôle d'une cellule mémoire flash de type NOR pour programmer cette cellule de façon optimale, compte tenu d'un jeu de paramètres comprenant une valeur cible de la fenêtre de programmation et une valeur cible du courant de drain de la cellule mémoire.

Selon l'invention, l'impulsion de tension optimale est définie par une rampe de tension depuis un niveau de tension initial non-nul pendant une durée de programmation. Le procédé de détermination de cette impulsion comprend les étapes suivantes :

- mesurer dynamiquement le courant de drain de la cellule mémoire lorsqu'une impulsion de tension de forme rectangulaire est appliquée sur la grille de contrôle ;
- prévoir un transistor équivalent à la cellule mémoire et comprenant une électrode de grille et une électrode de drain, de sorte que le courant de drain du transistor est égal au courant de drain de la cellule mémoire lorsque l'électrode de grille du transistor est portée à un potentiel égal au potentiel de la grille flottante de la cellule mémoire ;
- mesurer dynamiquement le courant de drain du transistor en fonction du potentiel de l'électrode de grille du transistor ;
- déterminer le potentiel de la grille flottante lors de l'impulsion de tension de forme rectangulaire, à partir de la mesure du courant de drain de la cellule mémoire et de la mesure du courant de drain du transistor ;
- déterminer, respectivement à partir de la valeur cible de courant de drain, du potentiel de la grille flottante lors de l'impulsion de tension de forme rectangulaire et de la valeur cible de fenêtre de programmation, le niveau de tension initial, la pente de la rampe de tension et la durée de programmation, de sorte que le courant de drain de la cellule mémoire pendant l'impulsion de tension optimale soit sensiblement égal à la valeur cible de courant de drain.

En outre, pendant la mesure du courant de drain de la cellule mémoire, le drain de la cellule mémoire est porté à un potentiel constant identique à celui de l'électrode de drain du transistor pendant la mesure du courant de drain du transistor.

Les impulsions de tension susmentionnées sont appliquées sur la grille de contrôle de la cellule mémoire. On pourra donc également les appeler « impulsions de grille ».

Grâce à ce procédé, on obtient une impulsion de grille permettant de maintenir une efficacité de programmation constante tout au long de la programmation. On appelle efficacité de programmation le rapport entre la charge électrique stockée dans la grille flottante et celle « perdue » dans le drain. Une efficacité constante se traduit par des courants de grille et de drain constants. Cela permet notamment de profiter pleinement des capacités des pompes de charge alimentant la cellule mémoire flash. Le courant de grille du transistor à grille flottante est le courant d'électrons à travers l'oxyde tunnel jusqu'à la grille flottante. Il détermine la vitesse à laquelle on écrit la cellule mémoire flash.

L'impulsion de grille optimale satisfait bien sûr les paramètres de programmation de la cellule mémoire flash, autrement dit le cahier des charges fixé par le fabricant de la cellule, puisqu'elle a été déterminée à partir de ces paramètres.

Cette détermination « a priori » de l'impulsion optimale, c'est-à-dire du niveau de tension initial de la rampe, de la pente de la rampe et de la durée de la programmation, est rendue possible grâce au fait qu'on utilise un transistor équivalent pour mesurer le potentiel de la grille flottante de la cellule mémoire. Dès lors qu'on connait le potentiel de la grille flottante, plusieurs méthodes, graphiques ou numériques, permettent de déterminer la pente et la durée de l'impulsion optimale.

Le procédé de détermination selon l'invention peut également présenter une ou plusieurs des caractéristiques ci-dessous, considérées individuellement ou selon toutes les combinaisons techniquement possibles :

- le niveau de tension initial est déterminé à partir de la mesure du courant de drain de la cellule mémoire au début de l'impulsion de tension de forme rectangulaire, en relevant la valeur du potentiel appliqué sur la grille de contrôle de la cellule mémoire pour laquelle le courant de drain est égal à la valeur cible de courant de drain de la cellule mémoire ;
- la pente de la rampe de tension est déterminée à partir de la dérivée du potentiel de la grille flottante, quand le potentiel de la grille flottante atteint une valeur cible du potentiel de la grille flottante correspondant à la valeur cible de courant de drain ;
- la durée de programmation est déterminée à partir de la valeur cible de fenêtre de programmation et de la pente de la rampe de tension ; et
- le transistor équivalent à la cellule mémoire à programmer est constitué d'une cellule mémoire flash de test, de géométrie identique à la cellule mémoire flash à programmer, ayant une grille flottante et une grille de contrôle en court-circuit.

Un autre aspect de l'invention concerne un produit programme d'ordinateur comportant des instructions pour mettre en oeuvre le procédé de détermination décrit ci-dessus, lorsqu'il est exécuté par un ordinateur.

## BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- la figure 1, précédemment décrite, représente une cellule mémoire flash selon l'art antérieur ;
- la figure 2, précédemment décrite, représente le courant de drain et la tension de grille de la cellule de la figure 1 en fonction du temps, lors d'une programmation classique de cette cellule ;
- la figure 3 représente une impulsion de tension permettant de programmer la cellule mémoire flash de façon optimale ;
- la figure 4 représente la cellule mémoire flash de la figure 1 et un transistor équivalent à cette cellule mémoire flash ;
- les figures 5A à 5C représentent des étapes d'un procédé de détermination d'une impulsion de tension optimale selon l'invention, permettant de déterminer le potentiel de la grille flottante de la cellule mémoire flash lors de la programmation classique ;
- la figure 6 représente une étape permettant de déterminer le niveau de tension initial de l'impulsion de la figure 3, d'après un mode de mise en oeuvre préférentiel du procédé selon l'invention ;
- les figures 7A et 7B représentent des étapes permettant de déterminer la pente de la rampe dans l'impulsion de la figure 3, d'après le mode de mise en oeuvre préférentiel du procédé selon l'invention ;
- la figure 8 est un exemple de mise en oeuvre du procédé de détermination selon l'invention, montant trois impulsions de tension optimales et le courant de drain de la cellule mémoire lorsque ces impulsions servent à programmer la cellule mémoire flash ;
- la figure 9 est un abaque représentant le compromis entre les performances de la cellule mémoire flash, en termes de consommation électrique, de courant de drain et de fenêtre de programmation.

Pour plus de clarté, les éléments identiques ou similaires sont repérés par des signes de références identiques sur l'ensemble des figures. Par ailleurs, sur certaines des figures, les courants et potentiels électriques sont exprimés en unité arbitraire (« a.u. », pour « arbitrary unit » en anglais).

## DESCRIPTION DÉTAILLÉE D'AU MOINS UN MODE DE RÉALISATION

Dans la description qui suit, on appelle « cellule mémoire flash » une mémoire EEPROM-Flash unitaire (i.e. d'une capacité de 1 bit) de type NOR. Cette cellule peut être embarquée dans un circuit de test, pour développer et qualifier la technologie EEPROM-Flash, ou constituée la base d'un circuit mémoire flash. Un circuit mémoire flash, ou matrice mémoire, comprend une pluralité de ces cellules mémoire arrangées en lignes et en colonnes. Les circuits mémoire EEPROM-Flash de type NOR équipent aujourd'hui de nombreux dispositifs électroniques, par exemple les téléphones portables, pour stocker tout type d'informations, en particulier des programmes.

Comme décrit précédemment (Fig.1), une cellule mémoire flash est munie d'un transistor comprenant une grille de contrôle, une grille flottante, des régions de drain et de source formées dans un substrat semi-conducteur. La grille de contrôle, le drain, la source et le substrat constituent des électrodes de commande, notées respectivement G, D, S et B. Ces électrodes permettent de polariser le transistor pour réaliser des opérations de programmation (ou écriture), d'effacement ou de lecture de la cellule mémoire. On notera ci-après le potentiel d'une électrode ou le courant traversant une électrode par le symbole approprié du potentiel ou du courant (V ou I), suivi de la lettre désignant l'électrode. Par exemple, « Vg » désigne le potentiel de la grille de contrôle G et « Id » désigne le courant dans l'électrode de drain D.

Dans cette cellule mémoire flash, le potentiel $V_{FG}(t)$ de la grille flottante au cours du temps dépend des polarisations $Vg(t)$ et $Vd(t)$ du transistor - respectivement sur la grille de contrôle G et sur le drain D - et de la charge d'électrons $Q_{FG}(t)$ dans la grille flottante. Il s'écrit :

$$V_{FG}(t) = \alpha_G.Vg(t) + \alpha_D.Vd(t) + \frac{Q_{FG}(t)}{C_{tot}} \qquad (1)$$

Dans la relation ci-dessus, $\alpha_G$ et $\alpha_D$ sont respectivement les facteurs de couplage de la grille de contrôle et du drain (fixés par l'architecture de la cellule), et Ctot est la capacité totale de la cellule.

Ainsi, lorsque la cellule est habituellement programmée à un potentiel $Vd(t)$ constant ($Vd(t) = Vd_{PROG}$) et à un potentiel Vg(t) constant, l'évolution du potentiel $V_{FG}(t)$ de la grille flottante ne dépend que de la charge d'électrons $Q_{FG}(t)$ dans la grille flottante. La diminution de cette charge (ou son augmentation en valeur absolue, la charge $Q_{FG}(t)$ étant négative) au cours de la programmation provoque donc une diminution du potentiel $V_{FG}(t)$ de la grille flottante. Cela explique d'une part l'augmentation de la tension de seuil du transistor à grille flottante et d'autre part la diminution du courant de drain Id(t), lorsqu'une impulsion de grille rectangulaire est appliquée sur l'électrode de grille (Fig.2).

Plutôt que d'appliquer une impulsion de grille rectangulaire, on souhaite appliquer sur la grille de contrôle de la cellule mémoire une impulsion de tension permettant de maintenir une efficacité de programmation constante pendant toute la durée de programmation, autrement dit des courants de drain Id(t) et de grille Ig(t) constants pendant la programmation. Un courant de drain Id(t) constant implique un potentiel $V_{FG}(t)$ de la grille flottante constant. Il en découle l'équation suivante (tirée de la relation (1) précédente) :

$$\frac{dV_{FG}(t)}{dt} = 0 = \alpha_G \cdot \frac{dVg(t)}{dt} + \frac{1}{C_{tot}} \frac{dQ_{FG}(t)}{dt}$$

d'où :

$$\frac{dVg(t)}{dt} = -\frac{1}{\alpha_G \cdot C_{tot}} \cdot \frac{dQ_{FG}(t)}{dt} = -\frac{Ig(t)}{\alpha_G \cdot C_{tot}} = cte \qquad (2)$$

Il apparait donc qu'une augmentation linéaire du potentiel Vg(t) pendant la programmation est nécessaire pour assurer une efficacité de programmation constante.

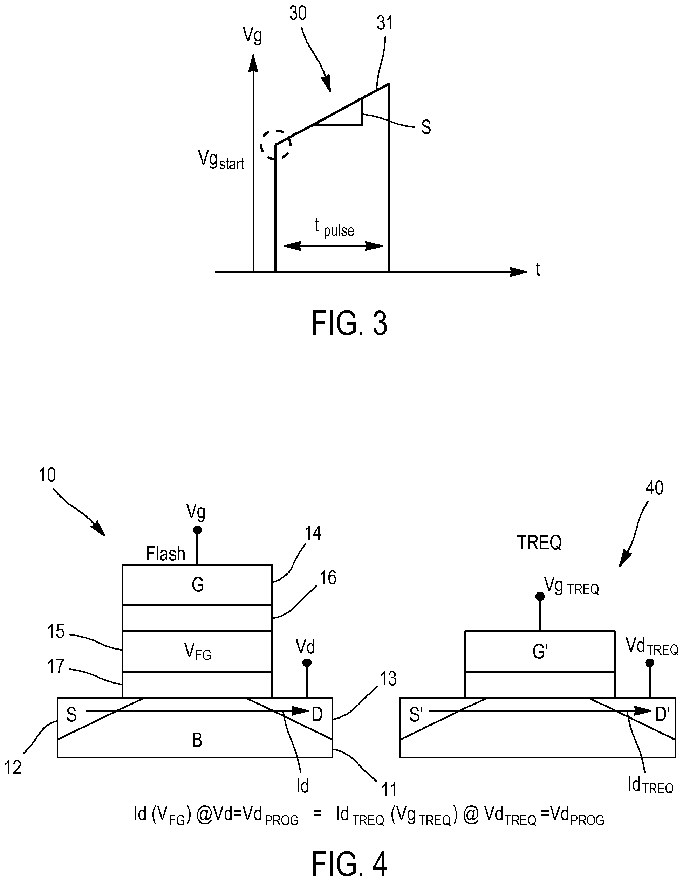

La figure 3 montre la forme de l'impulsion de grille 30 permettant cette programmation optimale de la cellule mémoire flash. L'impulsion 30 comprend, depuis un niveau de tension initial $Vg_{start}$ non-nul, une rampe 31 de pente S positive. La durée de l'impulsion 30, notée $t_{pulse}$, est la durée de programmation et correspond à la période de temps t où le potentiel Vg est non-nul, c'est-à-dire à la durée de la rampe 31.

Cette forme d'impulsion de grille permet de compenser la diminution de la charge $Q_{FG}$ dans la grille flottante liée au piégeage des électrons, lors de la programmation de la cellule mémoire. En effet, en augmentant progressivement le potentiel Vg(t) appliqué sur la grille de contrôle de la cellule mémoire, on augmente la valeur du paramètre $\alpha_G$. Vg(t) dans la relation du potentiel $V_{FG}(t)$ (relation (1)).

Déterminer l'impulsion de grille 30 optimale pour programmer la cellule mémoire flash consiste à déterminer la pente S de la rampe, le niveau de tension initial $Vg_{start}$ et la durée de l'impulsion $t_{pulse}$, en se fixant comme objectif d'atteindre une valeur cible de la fenêtre de programmation, notée $PW_{TG}$, et la valeur cible $Id_{TG}$ du courant de drain (c'est-à-dire la valeur à laquelle on souhaite maintenir le courant de drain Id(t)). Au moins l'un de ces paramètres, la pente S, requiert au préalable de déterminer le potentiel $V_{FG}(t)$ de la grille flottante lors d'une programmation classique. Par « programmation classique », on entend une programmation au moyen d'une impulsion de grille de forme rectangulaire.

La détermination du potentiel $V_{FG}(t)$ repose sur l'utilisation d'un transistor équivalent à la cellule mémoire dont on veut optimiser la programmation.

La figure 4 représente schématiquement ce transistor équivalent 40 (nommé également TREQ), aux côtés de la cellule mémoire flash 10 de la figure 1. Comme la cellule mémoire 10, le transistor 40 comprend une électrode de grille G' et une électrode de drain D'. Le transistor 40 est configuré de sorte que son courant de drain $Id_{TREQ}$ soit égal au courant de drain Id de la cellule mémoire 10, lorsque l'électrode de grille G' du transistor 40 est portée à un potentiel $Vg_{TREQ}$ égal au potentiel de la grille flottante $V_{FG}$ de la cellule mémoire 10 et lorsque l'électrode de drain D' du transistor 40 est porté au même potentiel que le drain de la cellule 10 (Vd = $Vd_{TREQ}$ = $Vd_{PROG}$).

Le transistor équivalent 40 est, de préférence, constitué d'une cellule mémoire flash de test, de géométrie identique à la cellule mémoire flash 10, et dans laquelle la grille flottante et la grille de contrôle sont en court-circuit. La grille flottante et la grille de contrôle de cette cellule de référence forment ainsi l'électrode de grille G' du transistor équivalent 40.

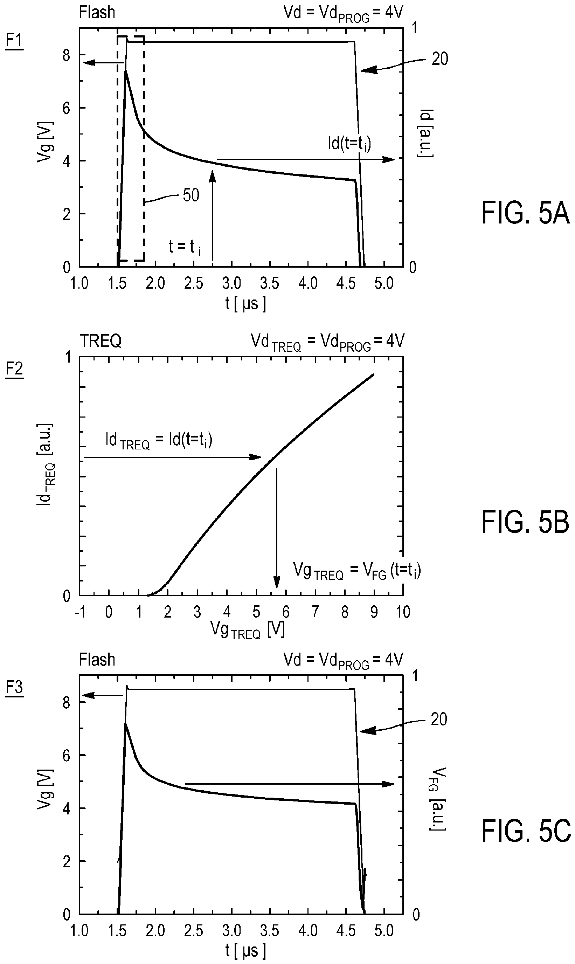

Les figures 5A à 5C représentent trois étapes F1 à F3 d'un procédé permettant de déterminer l'impulsion de grille optimale 30 de la figure 3, compte tenu des paramètres de programmation $PW_{TG}$ et $Id_{TG}$. Ces étapes F1 à F3 visent à déterminer, à l'aide du transistor équivalent 40, le potentiel $V_{FG}(t)$ de la grille flottante lors d'une programmation classique de la cellule mémoire 10.

A l'étape F1 de la figure 5A, le courant de drain Id de la cellule mémoire flash 10 est mesuré dynamiquement, pendant qu'une impulsion de tension 20 rectangulaire est appliquée sur l'électrode de grille de la cellule (potentiel Vg(t)).

Le drain de la cellule mémoire est porté à un potentiel $Vd_{PROG}$, par exemple égal à 4 V, au moins pendant toute la durée de l'impulsion 20. Cette mesure s'effectue de préférence à l'aide d'un appareil PIV (« Pulsed I-V system » en anglais) ou FMU (« Fast Measurement Unit »), en relevant par exemple un point toutes les 10 ns. On peut citer à titre d'exemple le modèle FMU « B1530 » commercialisé par la société « Keysight Technologies » ou le modèle PIV « 4225-RPM » commercialisé par la société « Keithley Instruments ».

Par ailleurs, en F2, on mesure le courant de drain $Id_{TREQ}$ du transistor équivalent 40 en fonction de son potentiel de grille $Vg_{TREQ}$. Cette mesure s'effectue également de façon dynamique, et de préférence dans les mêmes conditions que la mesure de l'étape F1 (même appareil, même durée d'échantillonnage...). En outre, le drain D' du transistor 40 est porté au même potentiel $Vd_{PROG}$ = 4 V que précédemment.

Les deux mesures étant indépendantes, l'étape F1 et l'étape F2 peuvent être réalisées dans n'importe quel ordre.

L'étape F3 représentée à la figure 5C consiste à déterminer le potentiel de la grille flottante $V_{FG}(t)$ lors de l'impulsion de grille 20, à partir de la mesure F1 du courant de drain $Id(t)$ de la cellule mémoire 10 (Fig.5A) et de la caractéristique $Id_{TREQ}(Vg_{TREQ})$ du transistor 40 relevée à l'étape F2 (Fig.5B). Pour ce faire, on peut déterminer le courant de drain $Id(t = t_i)$ correspondant à un temps $t_i$ donné sur le relevé de la figure 5A, reporter ce courant sur la caractéristique $Id_{TREQ}(Vg_{TREQ})$ de la figure 5B et en déduire le potentiel $Vg_{TREQ}$ correspondant. Sachant que le courant Id de la cellule mémoire flash 10 est égal au courant $Id_{TREQ}$ du transistor 40 si et seulement si le potentiel $V_{FG}$ de la grille flottante est égal au potentiel de grille $Vg_{TREQ}$ du transistor (Fig.4), cela permet d'obtenir la valeur du potentiel de la grille flottante $V_{FG}$ au temps $t_i$ ($V_{FG}(t = t_i)$). En répétant ces opérations pour plusieurs valeurs de temps t, on reconstruit point par point la courbe $V_{FG}(t)$ représentant le potentiel de la grille flottante en fonction du temps.

Autrement dit, la caractéristique $Id_{TREQ}(Vg_{TREQ})$ de la figure 5B permet d'établir le lien entre le courant de drain $Id(t)$ de la cellule mémoire 10 et le potentiel $V_{FG}(t)$ de la grille flottante.

Enfin, lors d'une dernière étape du procédé, on détermine les caractéristiques de l'impulsion de grille optimale 30, à savoir le potentiel de grille $Vg_{start}$ au départ de la rampe 31, la pente S de la rampe 31 et la durée de l'impulsion $t_{pulse}$, de sorte que le courant de drain Id de la cellule mémoire flash pendant la programmation optimale atteigne la valeur cible $Id_{TG}$ et que la fenêtre de programmation de la cellule soit égale à la valeur cible $PW_{TG}$.

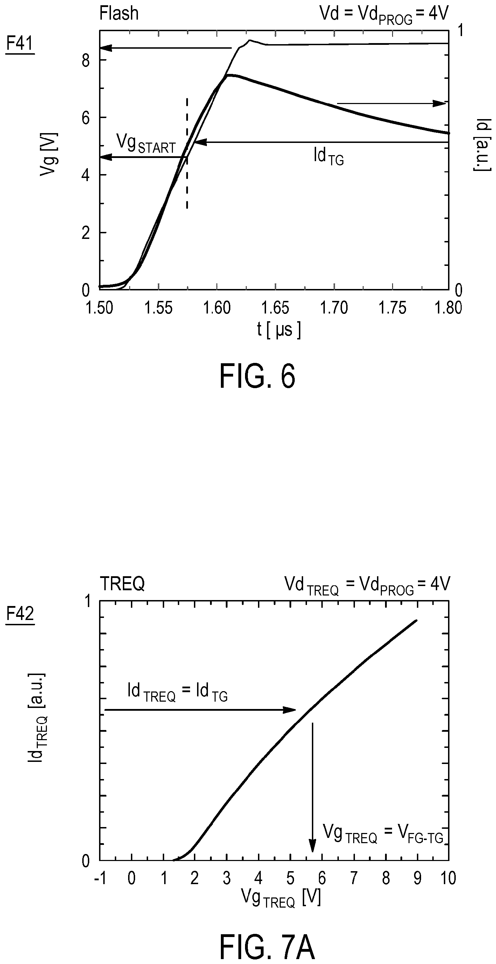

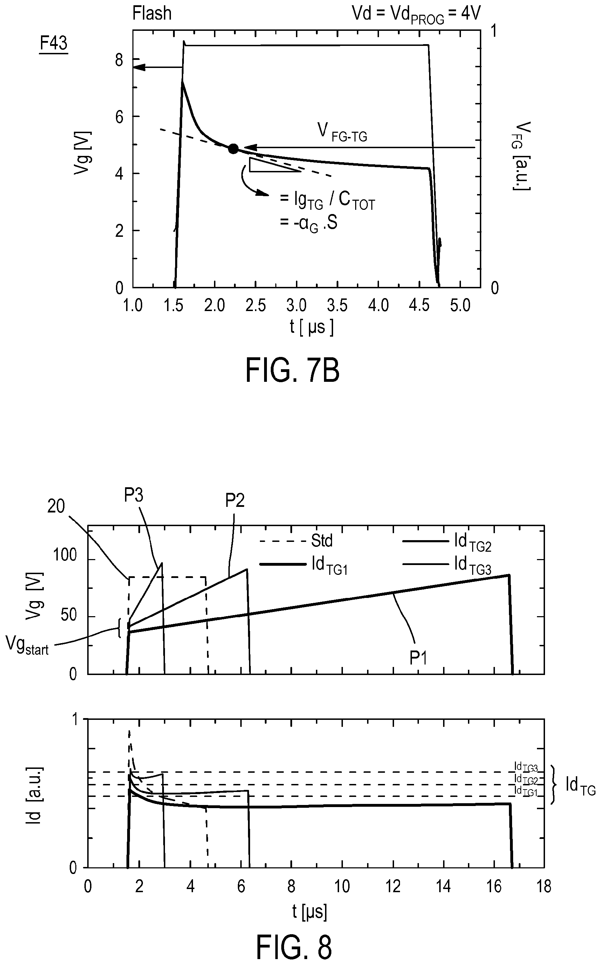

Dans un mode de mise en oeuvre préférentiel du procédé de détermination, cette dernière étape est décomposée en trois sous-étapes, dont deux sont représentées par les figures 6 et 7, chacune de ces sous-étapes visant à déterminer l'une de ces caractéristiques.

Le niveau de tension initial $Vg_{start}$ est la valeur du potentiel Vg à appliquer sur la grille de contrôle de la cellule mémoire au début de la programmation, i.e. en l'absence ou presque de charges électriques dans la grille flottante, afin d'obtenir un courant de drain Id égal à la valeur cible $Id_{TG}$. Il convient donc d'établir le lien entre le courant de drain Id et le potentiel Vg lorsque la cellule est dans l'état effacé.

Ce lien est directement donné par la mesure F1 du courant de drain $Id(t)$ de la cellule mémoire flash, lorsqu'on programme la cellule mémoire de façon classique (Fig.5A). Ainsi, à l'étape F41 de la figure 6, le niveau de tension initial $Vg_{start}$ est avantageusement déterminé à partir de la mesure du courant de drain $Id(t)$ au début de l'impulsion de grille rectangulaire 20, en relevant la valeur du potentiel de grille Vg pour laquelle le courant de drain Id est égal à la valeur cible de courant de drain $Id_{TG}$.

La figure 6 est un graphe représentant à la fois le courant de drain $Id(t)$ et le potentiel de grille $Vg(t)$ (à l'instar de la figure 5A), pendant une période de temps correspondant au début de l'impulsion rectangulaire 20 (cette période étant repérée par un cadre 50 en traits pointillé sur la figure 5A). Ce graphe permet de déterminer simplement le niveau de tension initial $Vg_{start}$ de l'impulsion optimale 30. La valeur cible $Id_{TG}$ du courant de drain est d'abord reportée sur ce graphe, pour déterminer l'instant t de la programmation classique où le courant de drain Id de la grille flottante est égal à la valeur cible $Id_{TG}$. Puis, le potentiel de grille Vg à ce même instant est déterminé, il est égal au niveau de tension initial $Vg_{start}$.

Comme indiqué précédemment, la pente S de l'impulsion de grille optimale 30 (Fig.3) permet de compenser la diminution de la charge $Q_{FG}$ dans la grille flottante se produisant lors de la programmation classique, afin que le courant de drain Id se maintienne à la valeur cible $Id_{TG}$. La pente S étant la dérivée temporelle du potentiel de grille $Vg(t)$, son expression est directement donnée par l'équation (2) :

$$S = \frac{dVg(t)}{dt} = -\frac{Ig(t)}{\alpha_G . C_{tot}} = -\frac{Ig_{TG}}{\alpha_G . C_{tot}}$$

où $Ig_{TG}$ est la valeur que prend le courant de grille Ig pendant la programmation de la cellule mémoire ($Ig(t) = cte = Ig_{TG}$), cette valeur étant appelée par la suite « valeur cible du courant de grille ».

Le courant de grille $Ig(t)$ pendant la programmation classique s'écrit :

$$Ig(t) = C_{tot} . \frac{dV_{FG}(t)}{dt}$$

La valeur cible $Ig_{TG}$ du courant de grille est donc égale à la capacité totale Ctot de la cellule mémoire multipliée par la dérivée du potentiel de la grille flottante $V_{FG}(t)$, à un instant t de la programmation classique où le potentiel de la grille flottante $V_{FG}(t)$ atteint une valeur $V_{FG-TG}$ - dite valeur cible du potentiel de la grille flottante - correspondant à la valeur cible $Id_{TG}$ du courant de drain.

L'expression de la pente S devient alors :

$$S = -\frac{Ig_{TG}}{\alpha_G . C_{tot}} = -\frac{1}{\alpha_G} \frac{dV_{FG}(t)}{dt}\bigg|_{t=t_{V_{FG}(t)=V_{FG-TG}}}$$

Ainsi, dans le mode de mise en oeuvre préférentiel du procédé de détermination, la pente S peut être déterminée simplement et rapidement à partir de la dérivée du potentiel de la grille flottante $V_{FG}(t)$ lorsque celui-ci est égal à la valeur cible $V_{FG-TG}$, soit par calcul grâce à l'équation ci-dessus, soit graphiquement au moyen du relevé du potentiel de la grille flottante $V_{FG}(t)$.

La figure 7A représente, lors d'une étape F42 du procédé, une façon de déterminer cette valeur cible $V_{FG-TG}$ du potentiel de la grille flottante. Pour mémoire, lorsque le courant de drain $Id_{TREQ}$ du transistor équivalent 40 est égal au courant de drain Id de la cellule mémoire 10, cela signifie que la grille de contrôle du transistor et la grille flottante de la cellule mémoire sont au même potentiel (cf. Fig.4). Pour déterminer la valeur cible $V_{FG-TG}$, il suffit donc de relever sur la caractéristique $IdT_{REQ}(Vg_{TREQ})$ de la figure 5B le potentiel $Vg_{TREQ}$ pour lequel on obtient $Id_{TREQ} = Id_{TG}$.

La figure 7B représente une étape F43 du procédé dans laquelle la pente S est déterminée graphiquement à partir du relevé du potentiel de la grille flottante $V_{FG}(t)$ issu de l'étape F3 (figure 5C). On détermine d'abord le point de la courbe $V_{FG}(t)$ ayant pour ordonnée la valeur cible $V_{FG-TG}$, puis on mesure la pente de la courbe $V_{FG}(t)$ à ce point pour en déduire la pente S (en divisant la pente de la courbe $V_{FG}(t)$ par $-\alpha_G$).

La durée $t_{pulse}$ de l'impulsion optimale 30, autrement dit la durée de programmation, influe directement sur la fenêtre de programmation de la cellule mémoire. La durée $t_{pulse}$ est donc déterminée à partir de la valeur cible $PW_{TG}$ de la fenêtre de programmation.

La valeur cible $PW_{TG}$ de la fenêtre de programmation est donnée par la relation suivante :

$$PW_{TG} = PW(t = t_{pulse}) = \frac{-Q_{FG}(t = t_{pulse})}{\alpha_G . C_{tot}} = \frac{-\int_{t_{pulse}} Ig(t) . dt}{\alpha_G . Ctot}$$

Puisque le courant de grille $Ig(t)$ est supposé constant pendant toute la durée de programmation $t_{pulse}$ ($Ig(t) = $ cte $= Ig_{TG}$), l'équation précédente se simplifie sous la forme :

$$PW_{TG} = \frac{-t_{pulse} . Ig_{TG}}{\alpha_G . C_{tot}}$$

La durée $t_{pulse}$ de l'impulsion optimale vaut donc :

$$t_{pulse} = \frac{-PW_{TG} . \alpha_G . C_{tot}}{Ig_{TG}} = \frac{PW_{TG}}{S}$$

Ainsi, une façon simple et rapide de déterminer la durée $t_{pulse}$ consiste à calculer le rapport entre la valeur cible $PW_{TG}$ de la fenêtre de programmation et la pente S de la rampe de tension, cette dernière ayant déterminée précédemment à l'étape F43.

La figure 8 représente, à titre d'exemple, trois impulsions de grille optimales P1, P2 et P3 déterminées grâce au procédé selon l'invention, ainsi que les relevés du courant de drain Id de la cellule mémoire flash lors de l'application de ces impulsions. A titre de comparaison, on a représenté l'impulsion de grille rectangulaire 20 classiquement utilisée pour programmer la cellule mémoire flash et le courant de drain Id correspondant, soit des courbes identiques (au moins dans la forme) à celles de la figure 2.

Les impulsions P1, P2 et P3 ont été déterminées pour une valeur cible de fenêtre de programmation $PW_{TG}$ égale à 6 V et pour trois valeurs cible du courant de drain : respectivement $Id_{TG1}$, $Id_{TG2}$ et $Id_{TG3}$ (avec $Id_{TG1} < Id_{TG2} < Id_{TG3}$).

Les relevés du courant de drain Id montrent que, pour chaque impulsion optimale P1 à P3, le courant de drain Id (en trait plein) est sensiblement constant, contrairement au courant de drain provoqué par une impulsion rectangulaire 20 (en traits pointillés).

Une efficacité de programmation constante est donc obtenue grâce à ces impulsions optimales. En outre, la valeur cible $Id_{TG}$ du courant de drain est quasiment atteinte pour chaque impulsion optimale P1 à P3. L'écart entre le courant de drain Id(t) et la valeur cible $Id_{TG}$ correspondante observé dans ces exemples est attribuable aux variations de performances d'une cellule mémoire à l'autre (dues à la variabilité du procédé de fabrication). Ces variations concernent ici la cellule mémoire programmée et le transistor équivalent ayant servi à la détermination des impulsions optimales P1-P3, lui-même constitué d'une cellule mémoire flash. L'écart entre la valeur cible $Id_{TG}$ et la valeur réelle du courant de drain Id(t) est inférieur à 10 $\mu$A. Le procédé de détermination est donc satisfaisant en termes de précision.

Comme cela est visible sur la figure 8, le niveau de tension initial $Vg_{start}$ varie d'une impulsion optimale à l'autre, selon la valeur du courant de drain $Id_{TG}$ visée. En effet, plus le courant de drain souhaité est important, plus la polarisation initiale du transistor à grille flottante doit être élevée. De même, la pente de la rampe augmente avec la valeur cible $Id_{TG}$, car un courant de drain élevé a tendance à diminuer plus rapidement qu'un courant de drain faible. Par contre, la cellule mémoire s'écrit bien plus rapidement avec un courant de drain élevé, par exemple égal à $Id_{TG3}$, qu'avec un courant de drain faible, par exemple égal à $Id_{TG1}$. Il est donc normal, pour une même valeur cible de fenêtre de programmation, que l'impulsion P3 ait une durée plus faible que l'impulsion P1.

Certaines des étapes du procédé ci-dessus, en particulier l'étape F3 et l'étape qui lui succède, peuvent être mises en oeuvre par un logiciel. Ce logiciel détermine, à partir des mesures de courant de drain sur la cellule mémoire flash (étape F1) et sur le transistor équivalent (étape F2), l'impulsion de grille optimale qui satisfait aux paramètres de programmation $Id_{TG}$ et $PW_{TG}$ renseignés par l'utilisateur dans le logiciel. Grâce à ce logiciel, on peut simuler rapidement un grand nombre d'impulsions optimales, en utilisant les mêmes mesures de courant de drain sur la cellule et sur le transistor équivalent. Une seule opération de programmation classique de la cellule mémoire est donc nécessaire. Le logiciel est, de préférence, installé sur un ordinateur relié à l'appareil de mesure PIV ou FMU. Ainsi, l'ordinateur exécute un programme qui commande l'appareil de mesure pour effectuer les mesures dynamiques de courant, récupère les données de mesure, et compile ces données, par exemple au moyen d'un processeur, pour déterminer l'impulsion de tension optimale.

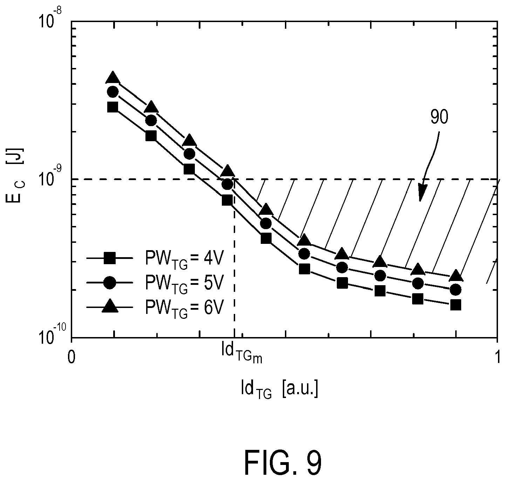

La figure 9 est un abaque de performances d'une cellule mémoire flash établi grâce au procédé de détermination selon l'invention. Il représente l'énergie Ec consommée par la cellule mémoire au cours de sa programmation en fonction de la valeur cible $Id_{TG}$ du courant de drain (en général la valeur du courant de drain à ne pas dépasser), et pour plusieurs valeurs cible $PW_{TG}$ de la fenêtre de programmation. Chaque point de cet abaque est obtenu en déterminant l'impulsion optimale correspondant à un couple $\{Id_{TG} ; PW_{TG}\}$ donné, puis en calculant l'énergie consommée Ec par la cellule mémoire lorsqu'elle est programmée avec cette impulsion. L'énergie consommée Ec est calculée en faisant l'intégrale du courant de drain Id(t) multiplié par le potentiel de drain Vd(t) de la cellule sur toute la durée de l'impulsion $t_{pulse}$.

Ce type d'abaque représente donc le compromis entre la fenêtre de programmation $PW_{TG}$, la consommation énergétique Ec et le courant maximal de drain $Id_{TG}$ de la cellule mémoire. Il permet aux fabricants de mémoire flash de choisir l'impulsion de grille optimale, en fonction du cahier des charges à respecter. Chaque courbe de l'abaque délimite une zone de fonctionnement interdit (en dessous de la courbe) et une zone de fonctionnement autorisé (au-dessus de la courbe). Par exemple, si le fabricant souhaite une fenêtre de programmation $PW_{TG}$ d'au moins 6 V et une énergie consommée Ec ne dépassant pas 1 nJ, le courant de drain maximal $Id_{TG}$ ne pourra être inférieur à la valeur $Id_{TGmin}$. Il devra choisir une impulsion optimale pour laquelle le compromis $PW_{TG}$ / Ec / $Id_{TG}$ appartient à la zone hachurée 90 sur la figure 9.

**Revendications**

1. Procédé de détermination d'une impulsion de tension optimale (30) pour programmer une cellule mémoire flash (10) de type NOR comprenant une grille flottante (15), une grille de contrôle (14) et un drain (13), ladite impulsion de tension optimale, à appliquer sur la grille de contrôle de la cellule mémoire, étant définie par une rampe de tension (31) depuis un niveau de tension initial non-nul ($Vg_{start}$) pendant une durée de programmation ($t_{pulse}$), le procédé comprenant les étapes suivantes :

   - fournir un jeu de paramètres comprenant une valeur cible de fenêtre de programmation ($PW_{TG}$) et une valeur cible de courant de drain (Id$_{TG}$) de la cellule mémoire (10) ;

- mesurer (F1) dynamiquement le courant de drain (Id) de la cellule mémoire lorsqu'une impulsion de tension de forme rectangulaire (20) est appliquée sur la grille de contrôle (14) ;

- prévoir un transistor (40) équivalent à la cellule mémoire (10) et comprenant une électrode de grille (G') et une électrode de drain (D'), de sorte que le courant de drain (Id$_{TREQ}$) du transistor est égal au courant de drain (Id) de la cellule mémoire lorsque l'électrode de grille (G') du transistor est portée à un potentiel (Vg$_{TREQ}$) égal au potentiel de la grille flottante (V$_{FG}$) de la cellule mémoire ;

- mesurer (F2) dynamiquement le courant de drain (Id$_{TREQ}$) du transistor en fonction du potentiel (Vg$_{TREQ}$) de l'électrode de grille (G') du transistor (40) ;

- déterminer (F3) le potentiel de la grille flottante (V$_{FG}$) lors de l'impulsion de tension de forme rectangulaire (20), à partir de la mesure du courant de drain (Id) de la cellule mémoire (10) et de la mesure du courant de drain (Id$_{TREQ}$) du transistor (40) ;

- déterminer, respectivement à partir de la valeur cible de courant de drain (Id$_{TG}$), du potentiel de la grille flottante (V$_{FG}$) lors de l'impulsion de tension de forme rectangulaire (20) et de la valeur cible de fenêtre de programmation (PW$_{TG}$), le niveau de tension initial (Vg$_{start}$), la pente (S) de la rampe de tension (31) et la durée de programmation (t$_{pulse}$), de sorte que le courant de drain (Id) de la cellule mémoire (10) pendant l'impulsion de tension optimale (30) soit sensiblement égal à la valeur cible de courant de drain (Id$_{TG}$) ;

et dans lequel le drain (D) est porté, pendant la mesure du courant de drain (Id) de la cellule mémoire (10), à un potentiel constant (Vd$_{PROG}$) identique à celui de l'électrode de drain (D') pendant la mesure du courant de drain (Id$_{TREQ}$) du transistor (40).

2. Procédé selon la revendication 1, dans lequel le niveau de tension initial (Vg$_{start}$) est déterminé à partir de la mesure du courant de drain (Id) de la cellule mémoire (10) au début (50) de l'impulsion de tension de forme rectangulaire (20), en relevant la valeur du potentiel (Vg) appliqué sur la grille de contrôle (G) de la cellule mémoire pour laquelle le courant de drain est égal à la valeur cible de courant de drain (Id$_{TG}$) de la cellule mémoire.

3. Procédé selon l'une des revendications 1 et 2, dans lequel la pente (S) de la rampe de tension (31) est déterminée (F43) à partir de la dérivée du potentiel (V$_{FG}$) de la grille flottante, quand le potentiel (V$_{FG}$) de la grille flottante atteint une valeur cible (V$_{FG-TG}$) du potentiel de la grille flottante correspondant à la valeur cible de courant de drain (Id$_{TG}$).

4. Procédé selon l'une quelconque des revendications 1 à 3, dans lequel la durée de programmation (t$_{pulse}$) est déterminée à partir de la valeur cible de fenêtre de programmation (PW$_{TG}$) et de la pente (S) de la rampe de tension (31).

5. Procédé selon la revendication 4, dans lequel la durée de programmation (t$_{pulse}$) est calculée à l'aide de la relation suivante :

$$t_{pulse} = \frac{PW_{TG}}{S}$$

où $PW_{TG}$ est la valeur cible de fenêtre de programmation et $S$ la pente de la rampe de tension (31).

6. Procédé selon l'une quelconque des revendications 1 à 5, dans lequel le transistor (40) équivalent à la cellule mémoire à programmer (10) est constitué d'une cellule mémoire flash de test, de géométrie identique à la cellule mémoire flash à programmer (10), ayant une grille flottante et une grille de contrôle en court-circuit.

7. Produit programme d'ordinateur comportant des instructions pour mettre en oeuvre un procédé selon l'une quelconque des revendications 1 à 6, lorsqu'il est exécuté par un ordinateur.

**Patentansprüche**

1. Bestimmungsverfahren eines optimalen Spannungsimpulses (30) zum Programmieren einer Flash-Speicherzelle (10) vom Typ NOR, umfassend ein schwebendes Gitter (15), ein Kontrollgitter (14) und einen Drän (13), wobei der genannte optimale Spannungsimpuls, der auf das Kontrollgitter der Speicherzelle anzuwenden ist, durch eine Spannungsrampe (31) ausgehend von einem anfänglichen Spannungsniveau ungleich Null (Vg$_{start}$) während einer Pro-

grammierdauer (t<sub>pulse</sub>) definiert ist,
wobei das Verfahren die folgenden Schritte umfasst:

- Liefern eines Parametersatzes, umfassend einen Zielwert eines Programmierfensters ($PW_{TG}$) und einen Zielwert eines Dränstroms ($Id_{TG}$) der Speicherzelle (10);
- dynamisches Messen (F1) des Dränstroms (Id) der Speicherzelle, wenn ein Spannungsimpuls in rechteckiger Form (20) auf das Kontrollgitter (14) angewendet ist;
- Vorsehen eines Transistors (40), der der Speicherzelle (10) gleichwertig ist und eine Gitterelektrode (G') und eine Dränelektrode (D') derart umfasst, dass der Dränstrom ($Id_{TREQ}$) des Transistors gleich dem Dränstrom (Id) der Speicherzelle ist, wenn die Gitterelektrode (G') des Transistors auf ein Potenzial ($Vg_{TREQ}$) gleich dem Potenzial des schwebenden Gitters ($V_{FG}$) der Speicherzelle erhöht ist;
- dynamisches Messen (F2) des Dränstroms ($Id_{TREQ}$) des Transistors in Abhängigkeit von dem Potenzial ($Vg_{TREQ}$) der Gitterelektrode (G') des Transistors (40);
- Bestimmen (F3) des Potenzials des schwebenden Gitters ($V_{FG}$) beim Spannungsimpuls in rechteckiger Form (20) ausgehend von der Messung des Dränstroms (Id) der Speicherzelle (10) und der Messung des Dränstroms ($Id_{TREQ}$) des Transistors (40);
- jeweils ab dem Zielwert eines Dränstroms ($Id_{TG}$) Bestimmen des Potenzials des schwebenden Gitters ($V_{FG}$) beim Spannungsimpuls in rechteckiger Form (20) und des Zielwertes eines Programmierfensters ($PW_{TG}$), des anfänglichen Spannungsniveaus ($Vg_{start}$), der Neigung (S) der Spannungsrampe (31) und der Programmierdauer (t<sub>pulse</sub>) derart, dass der Dränstrom (Id) der Speicherzelle (10) während des optimalen Spannungsimpulses (30) deutlich gleich dem Zielwert eines Dränstroms ($Id_{TG}$) ist;

und bei dem der Drän (D) während der Messung des Dränstroms (Id) der Speicherzelle (10) auf ein konstantes Potenzial ($Vd_{PROG}$) erhöht wird, das mit dem der Dränelektrode (D') während der Messung des Dränstroms ($Id_{TREQ}$) des Transistors (40) identisch ist.

2. Verfahren gemäß Anspruch 1, bei dem das anfängliche Spannungsniveau ($Vg_{start}$) ausgehend von der Messung des Dränstroms (Id) der Speicherzelle (10) zu Beginn (50) des Spannungsimpulses in rechteckiger Form (20) bestimmt ist, indem der Wert des Potenzials (Vg), der auf das Kontrollgitter (G) der Speicherzelle angewendet ist, für die der Dränstrom gleich dem Zielwert des Dränstroms ($Id_{TG}$) der Speicherzelle ist, abgelesen ist.

3. Verfahren gemäß einem der Ansprüche 1 und 2, bei dem die Neigung (S) der Spannungsrampe (31) ausgehend von der Ableitung des Potenzials ($V_{FG}$) des schwebenden Gitters bestimmt ist (F43), wenn das Potenzial ($V_{FG}$) des schwebenden Gitters einen Zielwert ($V_{FG-TG}$) des Potenzials des schwebenden Gitters erreicht, das dem Zielwert eines Dränstroms ($Id_{TG}$) gleichwertig ist.

4. Verfahren gemäß irgendeinem der Ansprüche 1 bis 3, bei dem die Programmierdauer (t<sub>pulse</sub>) ausgehend von dem Zielwert eines Programmierfensters ($PW_{TG}$) und der Neigung (S) der Spannungsrampe (31) bestimmt ist.

5. Verfahren gemäß Anspruch 4, bei dem die Programmierdauer (t<sub>pulse</sub>) mithilfe der folgenden Beziehung berechnet ist:

$$t_{pulse} = \frac{PW_{TG}}{S}$$

wobei $PW_{TG}$ der Zielwert eines Programmierfensters und S die Neigung der Spannungsrampe (31) ist.

6. Verfahren gemäß irgendeinem der Ansprüche 1 bis 5, bei dem der Transistor (40), der der zu programmierenden Speicherzelle (10) gleichwertig ist, aus einer Flash-Test-Speicherzelle mit identischer Geometrie zu der zu programmierenden Flash-Speicherzelle (10) gebildet ist, die ein schwebendes Gitter und ein Kontrollgitter mit Kurzschaltung aufweist.

7. Computerprogrammprodukt, das Anweisungen umfasst, um ein Verfahren gemäß irgendeinem der Ansprüche 1 bis 6 umzusetzen, wenn es durch einen Computer ausgeführt ist.

**Claims**

1. Method for determining an optimal voltage pulse (30) for programming a NOR-type flash memory cell (10) comprising a floating gate (15), a control gate (14) and a drain (13), said optimal voltage pulse, to apply to the control gate of the memory cell, being defined by a voltage ramp (31) from a non-zero initial voltage level ($Vg_{start}$) during a programming duration ($t_{pulse}$),
the method comprising the following steps:

   - providing a set of parameters including a programming window target value ($PW_{TG}$) and a drain current target value ($Id_{TG}$) of the memory cell (10);
   - dynamically measuring (F1) the drain current (Id) of the memory cell when a rectangular-shaped voltage pulse (20) is applied to the control gate (14);
   - providing a transistor (40) equivalent to the memory cell (10) and comprising a gate electrode (G') and a drain electrode (D'), such that the drain current ($Id_{TREQ}$) of the transistor is equal to the drain current (Id) of the memory cell when the gate electrode (G') of the transistor is brought to a potential ($Vg_{TREQ}$) equal to the potential of the floating gate ($V_{FG}$) of the memory cell;
   - dynamically measuring (F2) the drain current ($Id_{TREQ}$) of the transistor as a function of the potential ($Vg_{TREQ}$) of the gate electrode (G') of the transistor (40);
   - determining (F3) the potential of the floating gate ($V_{FG}$) during the rectangular-shaped voltage pulse (20), from the measurement of the drain current (Id) of the memory cell (10) and the measurement of the drain current ($Id_{TREQ}$) of the transistor (40);
   - determining, respectively from the drain current target value ($Id_{TG}$), the potential of the floating gate ($V_{FG}$) during the rectangular-shaped voltage pulse (20) and from the programming window target value ($PW_{TG}$), the initial voltage level ($Vg_{start}$), the slope (S) of the voltage ramp (31) and the programming duration ($t_{pulse}$), such that the drain current (Id) of the memory cell (10) during the optimal voltage pulse (30) is substantially equal to the drain current target value ($Id_{TG}$);

   and wherein the drain (D) is brought, during the measurement of the drain current (Id) of the memory cell (10), to a constant potential ($Vd_{PROG}$) identical to that of the drain electrode (D') during the measurement of the drain current ($Id_{TREQ}$) of the transistor (40).

2. Method according to claim 1, wherein the initial voltage level ($Vg_{start}$) is determined from the measurement of the drain current (Id) of the memory cell (10) at the start (50) of the rectangular-shaped voltage pulse (20), by measuring the value of the potential (Vg) applied to the control gate (G) of the memory cell for which the drain current is equal to the drain current target value ($Id_{TG}$) of the memory cell.

3. Method according to one of claims 1 and 2, wherein the slope (S) of the voltage ramp (31) is determined (F43) from the derivative of the potential ($V_{FG}$) of the floating gate, when the potential ($V_{FG}$) of the floating gate reaches a floating gate potential target value ($V_{FG-TG}$) corresponding to the drain current target value ($Id_{TG}$).

4. Method according to any one of claims 1 to 3, wherein the programming duration ($t_{pulse}$) is determined from the programming window target value ($PW_{TG}$) and from the slope (S) of the voltage ramp (31).

5. Method according to claim 4, wherein the programming duration ($t_{pulse}$) is calculated using the following relationship:

$$t_{pulse} = \frac{PW_{TG}}{S}$$

where $PW_{TG}$ is the programming window target value and S the slope of the voltage ramp (31).

6. Method according to any one of claims 1 to 5, wherein the transistor (40) equivalent to the memory cell to program (10) is comprised of a test flash memory cell, of identical geometry to the flash memory cell to program (10), having a floating gate and a control gate in short-circuit.

7. Computer program product comprising instructions for implementing a method according to anyone of claims 1 to 6, when it is executed by a computer.

10

Vg=7-10V

14

G

16

15

17

Vd=3-5V

12

S          D          13

B

11

$I_d$

## FIG. 1 (Art antérieur)

21

Flash          $Vd = Vd_{PROG} = 4V$

1

8          $Id_{MAX}$          20

P

6

Vg [V]          Id [a.u.]

4

2          $t_{pulse}$

0          0
1.0  1.5  2.0  2.5  3.0  3.5  4.0  4.5  5.0

t [ µs ]

## FIG. 2 (Art antérieur)

FIG. 3

$$Id\ (V_{FG})\ @Vd=Vd_{PROG}\ =\ Id_{TREQ}\ (Vg_{TREQ})\ @\ Vd_{TREQ}=Vd_{PROG}$$

FIG. 4

FIG. 5A

FIG. 5B

FIG. 5C

FIG. 6

FIG. 7A

Flash

$Vd = Vd_{PROG} = 4V$

F43

$V_{FG-TG}$

$= Ig_{TG} / C_{TOT}$
$= -\alpha_G . S$

FIG. 7B

Std $\qquad$ $Id_{TG2}$
$Id_{TG1}$ $\qquad$ $Id_{TG3}$

$Vg_{start}$

P1

P3 P2

$Id_{TG3}$
$Id_{TG2}$
$Id_{TG1}$

$Id_{TG}$

FIG. 8

FIG. 9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6040996 A

- US 5856946 A

**Littérature non-brevet citée dans la description**

- **V. DELLA MARCA et al.** Push the flash floating gate memories toward the future low energy application. *Solid-State Electronics,* 2013, vol. 79, 210-217